# EUROPÄISCHE PATENTSCHRIFT

(11) **EP 2 900 842 B1**
(45) Veröffentlichungstag und Bekanntmachung des Hinweises auf die Patenterteilung: **27.02.2019**
(21) Anmeldenummer: 13773660.9
(22) Anmeldetag: 27.09.2013
(51) Int. Cl.: C23C 14/32, C23C 14/06, C23C 28/00, B23B 27/14

(54) **WERKZEUG MIT TIALCRSIN-PVD-BESCHICHTUNG**
TOOL WITH TIALCRSIN PVD COATING
OUTIL À REVÊTEMENT DE TIALCRSIN DÉPOSÉ PAR DÉPÔT PHYSIQUE EN PHASE VAPEUR

(30) Priorität: 28.09.2012 DE 102012109254
(43) Veröffentlichungstag der Anmeldung: 05.08.2015
(73) Patentinhaber: Walter AG, 72072 Tübingen (DE)
(72) Erfinder: SCHIER, Veit, 70771 Echterdingen (DE)
(74) Vertreter: WSL Patentanwälte Partnerschaft mbB
(86) Internationale Anmeldenummer: PCT/EP2013/070165
(87) Internationale Veröffentlichungsnummer: WO 2014/049105

(56) Entgegenhaltungen:
- EP-A1- 1 939 327
- WO-A1-2005/085499
- WO-A1-2006/102780
- WO-A1-2012/005275
- JP-A- 2011 235 393

## Beschreibung

### Gegenstand der Erfindung

Die Erfindung betrifft ein Werkzeug mit einem Grundkörper aus Hartmetall, Cermet, Keramik, Stahl oder Schnellarbeitsstahl und einer darauf im PVD-Verfahren aufgebrachten ein- oder mehrschichtigen Verschleißschutzbeschichtung.

### Hintergrund der Erfindung

Schneidwerkzeuge, insbesondere Werkzeuge für die spanende Metallbearbeitung, bestehen aus einem Grundkörper, der beispielsweise aus Hartmetall, Cermet, Keramik, Stahl oder Schnellarbeitsstahl hergestellt ist. Zu Erhöhung der Standzeiten oder auch zu Verbesserung der Schneideigenschaften wird auf den Grundkörper häufig mittels CVD- oder PVD-Verfahren eine ein- oder mehrschichtige Verschleißschutzbeschichtung aus Hartstoffen aufgebracht. Bei den PVD-Verfahren unterscheidet man zwischen verschiedenen Verfahrensvarianten, wie Magnetronsputtern, Lichtbogenverdampfen (Arc-PVD), Ionenplattierung, Elektronenstrahlverdampfung und Laserablation. Magnetronsputtern und Lichtbogenverdampfen zählen zu den am häufigsten für die Beschichtung von Werkzeugen angewendeten PVD-Verfahren. Innerhalb einzelner PVD-Verfahrensvarianten gibt es wiederum unterschiedliche Modifikationen, wie beispielweise ungepulstes oder gepulstes Magnetronsputtern oder ungepulstes oder gepulstes Lichtbogenverdampfen usw.

Das Target im PVD-Verfahren kann aus einem reinen Metall oder einer Kombination von zwei oder mehr Metallen bestehen. Umfasst das Target mehrere Metalle, so werden alle diese Metalle gleichzeitig in die in dem PVD-Verfahren aufgebaute Lage einer Beschichtung eingebaut. Bei gemischtmetallischen Targets wird Mengenverhältnis der Metalle zueinander in der aufgebauten Lage im Wesentlichen von dem Mengenverhältnis der Metalle in dem Target bestimmt.

Zur Erzeugung bestimmter Metallverbindungen werden dem Reaktionsraum des PVD-Verfahrens reaktive Gase zugeführt, wie z.B. Stickstoff zur Erzeugung von Nitriden, Sauerstoff zur Erzeugung von Oxiden, kohlenstoffhaltige Verbindungen zur Erzeugung von Carbiden oder Gemische dieser Gase zur Erzeugung von entsprechenden Mischverbindungen, wie Carbonitriden, Oxicarbiden etc.

Die WO 96/23911 A1 beschreibt eine Verschleißschutzschicht auf einem Substrat, bestehend aus einer unmittelbar auf dem Substrat aufgebrachten Hartstofflage und darüber einer Abfolge von 10 bis 1000 weiteren Einzellagen, die abwechselnd aus einem metallischen Hartstoff und einem kovalenten Hartstoff mit einer Dicke der Einzellagen zwischen 1 und 30 nm bestehen. Durch die periodisch alternierende Anordnung von Einzellagen aus metallischen Hartstoffen und kovalenten Hartstoffen sollen die mechanischen und chemischen Eigenschaften der Verschleißschutzschicht verbessert werden.

Die WO 2006/041367 A1 beschreibt ein beschichtetes Schneidwerkzeug aus einem Hartmetallsubstrat und einer im PVD-Verfahren abgeschiedenen Beschichtung, die wenigstens eine Lage aus TiAIN mit einer Dicke von 1,5 bis 5 µm und einer Druckeigenspannung > 4 bis 6 GPa umfasst. Die TiAIN-Lage soll gegenüber bekannten Lagen eine verbesserte Haftung auf dem Untergrund aufweisen.

Die EP 2 298 954 A1 beschreibt ein Verfahren zur Herstellung eines beschichteten Schneidwerkzeugs, bei dem auf einem Substrat mittels PVD-Verfahren eine Hartstoffbeschichtung aufgebracht wird, beispielsweise TiAlN, TiAlCrN oder TiAlCrSiN, wobei während des Abscheidungsverfahrens die Bias-Spannung des Substrates variiert wird. Durch das Verfahren soll eine verbesserte Verschleißbeständigkeit und höhere Lebensdauer des Werkzeugs erzielt werden.

Die EP 1 992 717 beschreibt ein Target zur Abscheidung einer Hartstoffschicht im PVD-Verfahren, welches Ti, Al, Cr, Si, B, C und N innerhalb verschiedener Mengenbereiche enthalten kann.

Die EP 1 174 528 beschreibt ein Schneidwerkzeug mit einer mehrlagigen Verschleißschutzbeschichtung, welche eine erste Hartstofflage und eine zweite Hartstofflage umfasst, wobei die erste Hartstofflage eines oder mehrere der Metalle Ti, Al und Cr und eines oder mehrere der Nichtmetalle N, B, C und O enthält und die zweite Hartstofflage Si und eines oder mehrere der Metalle der Gruppen 4a, 5a und 6a des Periodensystems und Al und eines oder mehrere der Nichtmetalle N, B, C und O enthält.

Die WO2012/005275 A1 beschreibt ein beschichtetes Schneidwerkzeug.

Für bestimmte Metallbearbeitungsvorgänge, wie z.B. das Fräsen und Drehen, werden besonders hohe Anforderungen an das Werkzeug gestellt. Wichtige Parameter für solche Werkzeuge sind Hochtemperaturbeständigkeit, hohe Härte, hohe Risszähigkeit und ein hoher Elastizitätsmodul (E-Modul, Youngscher Modul).

Schneidwerkzeuge und deren Verschleißschutzbeschichtungen sind in der Regel für bestimmte Anwendungen ausgelegt, wobei hinsichtlich der vorgenannten Eigenschaften, soweit sie für die Anwendung wesentlich sind, üblicherweise Kompromisse eingegangen werden, da nicht alle gewünschten Eigenschaften gleichzeitig optimiert werden können. Es besteht daher ein Bedarf, die für bestimmte Anwendungen wichtigen Eigenschaften von Verschleißschutzbeschichtungen weiter zu verbessern.

Bekannte Ti₈₅Si₁₅N-Lagen in Verschleißschutzbeschichtungen besitzen beispielsweise sehr hohe Härte und sehr hohe E-Moduli, aber vergleichsweise schlechte tribochemische Eigenschaften bei hohen Temperaturen. Ähnliches trifft auf Al₇₀Cr₃₀N-Lagen zu. Im Gegensatz dazu zeigen Ti₅₀Al₅₀N-Lagen zwar besseres tribochemisches Verhalten bei hohen Temperaturen, aber sie besitzen eine geringere Härte und geringere E-Moduli.

### Aufgabe

Die Aufgabe der vorliegenden Erfindung bestand darin, ein Werkzeug für die spanabhebende Bearbeitung von Werkstoffen, insbesondere Stählen, bereitzustellen mit einer gegenüber dem Stand der Technik verbesserten Beschichtung mit hoher Härte, hoher Risszähigkeit, hohem Elastizitätsmodul und guter Hochtemperaturbeständigkeit, insbesondere für das Fräsen, Bohren und Drehen von Stählen.

### Beschreibung der Erfindung

Gelöst wird diese Aufgabe durch ein Werkzeug mit einem Grundkörper aus Hartmetall, Cermet, Keramik, Stahl oder Schnellarbeitsstahl und einer auf dem Grundkörper im PVD-Verfahren aufgebrachten mehrlagigen Verschleißschutzbeschichtung, wobei die Verschleißschutzbeschichtung wenigstens eine Lage
(A) TiₐAl₍₁₋ₐ₎N mit 0,33 ≤ a ≤ 1 und mit einer Lagendicke von 20 nm bis 3 µm
   und wenigstens eine Lage
(B) aus einer Abfolge von wenigstens 4 abwechselnd übereinander angeordneten Sub-Lagen Ti_{b}Si_{(1-b)}N und Al_{c}Cr_{(1-c)}N mit 0,70 ≤ b ≤ 0,98 und 0,3 ≤ c ≤ 0,75 und mit einer Lagendicke der Sub-Lagen von 0,5 nm bis 15 nm umfasst
   und optional weiterhin wenigstens eine Lage
(C) Ti_{d}Si_{(i-d)}N mit 0,70 ≤ d ≤ 0,98 und mit einer Lagendicke von 50 nm bis 1 µm umfasst,
wobei die Verschleißschutzbeschichtung weitere Hartstofflagen aufweisen kann und wobei die Lagen (A), (B) und (C) verfahrensbedingt pro Lage bis zu 10 At.-% weitere Metalle, B, C und/oder O enthalten können.

Es hat sich überraschend gezeigt, dass Werkzeuge der erfindungsgemäßen Art aufgrund der neuen Verschleißschutzbeschichtung verbesserte Zerspanergebnisse und geringeren Verschleiß zeigen als bekannte Werkzeuge nach dem Stand der Technik. Die erfindungsgemäße Verschleißschutzbeschichtung besitzt hohe Härte, hohe Risszähigkeit, einen hohen Elastizitätsmodul und gute Hochtemperaturbeständigkeit, was insbesondere für das Fräsen, Bohren und Drehen von Stählen von Vorteil ist.

Die erfindungsgemäßen Verschleißschutzbeschichtungen mit der Kombination aus TiAIN-Lagen (A) und Lagen (B) mit abwechselnd übereinander angeordneten TiSiN- und AlCrN-Sub-Lagen und optional TiSiN-Lagen (C) zeichnen sich durch eine höhere Verschleißbeständigkeit und längere Standzeiten aus, insbesondere durch weniger Abplatzen der Beschichtung an der Schneidkante.

Ohne dass die Erfinder sich hiermit an eine Theorie binden wollen, wird angenommen, dass in der Lage (B) der Wechsel der Lagenzusammensetzungen in den wenige Nanometer dünnen übereinander angeordneten TiSiN- und AlCrN-Sub-Lagen aufgrund der unterschiedlichen Gitterkonstanten in dem Gitter, das ein kubisch flächenzentriertes Gitter ist, zu einer Variation der Eigenspannungsverhältnisse der Lage (B) führt, welche die vorteilhaften Eigenschaften der erfindungsgemäßen Verschleißschutzbeschichtung begünstigt.

Die nur wenige Nanometer dünnen übereinander angeordneten TiSiN- und AlCrN-Sub-Lagen in der erfindungsgemäßen Lage (B) mit unterschiedlichen Zusammensetzungen lassen sich trotz ihrer geringen Dicke im Transmissionselektrodenmikroskop (TEM) nachweisen und unterscheiden. Dem Fachmann auf dem Gebiet ist die Technik hinlänglich bekannt.

In einer bevorzugten Ausführungsform der Erfindung weist die Lage (B) eine Abfolge von wenigstens 4 Sub-Lagen Ti_{b}Si_{(1-b)} und 4 Sub-Lagen Al_{c}Cr_{(1-c)}N abwechselnd übereinander angeordnet auf. Die Gesamtzahl der Sub-Lagen Ti_{b}Si_{(1-b)} und Al_{c}Cr_{(1-c)}N beträgt in dieser Ausführungsform somit wenigstens 8. Ist die Anzahl der Sub-Lagen Ti_{b}Si_{(1-b)} und Al_{c}Cr_{(1-c)}N zu gering, können gegenüber dem Stand der Technik zwar höhere Härten und höhere E-Moduli erzielt werden, jedoch wirkt sich eine zu geringe Dicke der Lage (B) nachteilig auf die Verschleißfestigkeit der Gesamtbeschichtung aus.

In einer weiteren bevorzugten Ausführungsform der Erfindung weist die Lage (B) eine Abfolge von höchstens 1500 Sub-Lagen Ti_{b}Si_{(1-b)} und 1500 Sub-Lagen Al_{c}Cr_{(1-c)}N abwechselnd übereinander angeordnet auf. Die Gesamtzahl der Sub-Lagen Ti_{b}Si_{(1-b)} und Al_{c}Cr_{(1-c)}N beträgt in dieser Ausführungsform somit höchstens 3000. Ist die Anzahl der Sub-Lagen Ti_{b}Si_{(1-b)} und Al_{c}Cr_{(1-c)}N zu hoch, führt dies zu einer zu hohen Gesamtdicke der Verschleißschutzbeschichtung mit der Folge, dass die Beschichtung im Schneidkantenbereich schneller versagt.

In einer weiteren bevorzugten Ausführungsform der Erfindung weist die Lage (B) eine Gesamtlagendicke von 40 nm bis 3 µm auf. Ist die Gesamtlagendicke der Lage (B) zu gering, verliert die Lage (B) die vorteilhaften mechanischen Eigenschaften. Ist die Gesamtlagendicke der Lage (B) zu hoch, führt dies zu einer zu hohen Gesamtdicker der Verschleißschutzbeschichtung mit der Folge, dass die Beschichtung im Schneidkantenbereich schneller versagt.

In einer weiteren bevorzugten Ausführungsform der Erfindung weist die Verschleißschutzbeschichtung eine der folgenden Lagenabfolgen auf, wobei m, n, o, p, q und r ganze Zahlen > 0 sind:

| | |
|---|---|
| [A-B]ₙ | mit 1≤n≤100, vorzugsweise 1≤n≤20, |
| ([A-B]ₙ-C)ₘ | mit 1≤n≤100, vorzugsweise 1≤n≤20, und 1≤m≤20, vorzugsweise 1≤m≤5 |
| A-[B-C]ₙ | mit 1≤n≤30 |
| [A-B-C]ₙ | mit 2≤n≤30 |
| {([A-B]ₒ-C)_{q}-(A-[B-C]ₚ)ᵣ}ₘ | mit 1≤o≤30, 1≤p≤30, 1≤q≤30, p+q≥2, (13q+25r)m≤500. |

Vorzugsweise ist die TiAIN-Lage (A) die innerste Lage der Verschleißschutzbeschichtung und in direktem Kontakt mit der Substratoberfläche des Grundkörpers. Die TiAIN-Lage (A) trägt zu einer sehr guten Haftung der Verschleißschutzbeschichtung auf der Substratoberfläche bei und verringert damit die Gefahr des Abplatzens oder Abschälens der Verschleißschutzbeschichtung.

In einer weiteren bevorzugten Ausführungsform der Erfindung weisen die Sub-Lagen Ti_{b}Si_{(1-b)}N und Al_{c}Cr(_{1-c})N Lagendicken von 1,0 nm bis 12 nm, besonders bevorzugt von 3,0 nm bis 9,0 nm auf.

Die erfindungemäßen Sub-Lagen Ti_{b}Si_{(1-b)}N und Al_{c}Cr_{(1-c)}N mit 0,70 ≤ b ≤ 0,98 und 0,3 ≤ c ≤ 0,75 in der Lage (B) weisen mit Vorteil kubisch flächenzentrierte Kristallstruktur auf.

Ist der Si-Gehalt in der Ti_{b}Si_{(1-b)}N-Lage zu hoch, besteht die Gefahr, dass die Lage amorph wird. Die Ti_{b}Si_{(1-b)}N-Lage hätte dann eine für den erfindungsgemäßen Zweck zu geringe Härte. Es wurde festgestellt, dass die Härte der Ti_{b}Si_{(1-b)}N-Lage bis zu einem Si-Gehalt von etwa 15 At.-%, d. h. b > 0,85, zunimmt und danach eine Abnahme der Härte eintritt. Innerhalb des erfindungsgemäßen Konzentrationsbereiches weist die Ti_{b}Si_{(1-b)}N-Lage eine hohe Härte und einen hohen E-Modul auf.

Ist der Al-Gehalt in der Al_{c}Cr_{(1-c)}N-Lage zu hoch, d. h. größer als 75 At.-%, besteht die Gefahr, dass die die Lage die hexagonale Kristallstruktur einnimmt, die für den erfindungsgemäßen Zweck eine zu geringe Härte besitzt und nicht hitzebeständig ist.

In einer weiteren bevorzugten Ausführungsform der Erfindung weist die Verschleißschutzbeschichtung eine Gesamtdicke von 0,5 µm bis 10 µm, vorzugsweise von 0,7 µm bis 5 µm, besonders bevorzugt 1,0 µm bis 3,0 µm, ganz besonders bevorzugt 1,5 µm bis 2,5 µm auf. Ist die Gesamtdicke der Verschleißschutzbeschichtung zu gering, tritt vorzeitiger Verschleiß an der Schneidkante auf aufgrund von zu hohem abrasivem und/oder tribochemischem Verschleiß und/oder aufgrund von Versagen des Substrats durch zu hohem Temperatureintrag. Ist die Gesamtlagendicke der Verschleißschutzbeschichtung zu hoch, wird die Gesamtdruckspannung der Schicht im Schneidkantenbereich zu hoch und die Verschleißschutzbeschichtung versagt adhäsiv oder kohäsiv oder es tritt mechanisches Versagen des Substrats, insbesondere bei Hartmetallsubstraten, ein.

Die Verschleißschutzbeschichtung des erfindungsgemäßen Werkzeugs kann in einer weiteren Ausführungsform weitere Hartstofflagen aufweisen. Zwischen dem Substrat und der erfindungsgemäßen Lagenabfolge, welche die Lagen (A), (B) und optional (C) umfasst, können zusätzliche Hartstofflagen oder Kombinationen davon vorhanden sein, z.B. TiAIN, TiN, AICrN, TiCN etc. Des Weiteren können über der erfindungsgemäßen Lagenabfolge als äußere Lagen Verschleißindikatorschichten, reine Metalllagen, z.B. Al, Zr oder Nb, oder auch Metalloxidlagen, z. B. Al₂O₃, [AlCr]₂O₃, ZrO₂ oder Cr₂O₃, vorhanden sein, sofern diese zusätzlichen Lagen die Eigenschaften des erfindungsgemäßen Werkzeugs nicht wesentlich beeinträchtigen.

In einer bevorzugten Ausführungsform weist die erfindungsgemäße Verschleißschutzbeschichtung wenigstens bereichsweise eine als äußerste Lage angeordnete dünne Verschleißerkennungsschicht, vorzugsweise eine TiN- oder ZrN-Schicht, mit einer Dicke von 0,1 bis 1,5 µm auf. Verschleißerkennungsschichten der vorgenannten Art sind an sich bekannt und dienen in erster Linie als Dekorschichten und/oder dazu anzuzeigen, ob und in welchem Umfang das Werkzeug bereits benutzt wurde und wie stark der im Laufe der Benutzung aufgetretene Verschleiß ist. Die dünne Verschleißerkennungsschicht wird bei der Benutzung des Werkzeugs erkennbar abgenutzt, und bei stärkerer Abnutzung wird die darunter liegende, meist andersfarbige Verschleißschutzschicht sichtbar.

Die erfindungsgemäße Verschleißschutzbeschichtung weist zweckmäßigerweise eine Vickers-Härte HV von 2500 bis 4000, vorzugsweise von 3000 bis 3500 auf. Die hohe Härte der erfindungsgemäßen Verschleißschutzbeschichtung hat besondere Vorteile bei der Metallbearbeitung, insbesondere beim Drehen und Fräsen, da diese Metallbearbeitungsverfahren unter den trennenden Verfahren mit geometrisch bestimmter Schneide diejenigen mit den höchsten Ansprüchen an den Schneidstoff hinsichtlich Härte, Zähigkeit, Verschleißfestigkeit und Temperaturbeständigkeit sind. Eine zu niedrige Härte hat den Nachteil, dass die Verschleißfestigkeit der Beschichtung abnimmt. Eine zu hohe Härte hat den Nachteil, dass die damit einhergehende Druckverspannung der Beschichtung überhöht wird und die Beschichtung an der Schneidkante zum Abplatzen neigt. In Kenntnis der vorliegenden Erfindung ist es dem Fachmann ohne weiteres möglich, durch Variation der Lagenzusammensetzungen und/oder der Lagenabfolge und/oder der Lagendicken geeignete Härtewerte der Verschleißschutzbeschichtung einzustellen.

Des Weiteren weist die erfindungsgemäße Verschleißschutzbeschichtung zweckmäßigerweise einen Elastizitätsmodul (E-Modul) von > 380 GPa, vorzugsweise von > 400 GPa auf. Bei äußerer Beanspruchung des Werkzeugs beim Zerspanvorgang werden in der Beschichtung und im Substrat mechanische Spannungen erzeugt, deren Höhe über den Elastizitätsmodul mit der eingebrachten elastischen Verformung verknüpft ist. Ist der Elastizitätsmodul der Beschichtung zu gering, entstehen innerhalb der Beschichtung geringe Spannungen bei mechanischer Verformung des Werkzeugs im Gebrauch, was mit dem Nachteil verbunden ist, dass die Beschichtung auch nur einen geringen Teil der Zerspankräfte aufnehmen kann. Ist der Elastizitätsmodul jedoch zu hoch, hat dies den Nachteil, dass bei mechanischer Verformung zu hohe Kräfte über die Beschichtung abgeleitet werden, wodurch sie vorzeitig zerstört werden kann.

Wie bereits ausgeführt wurde, ist für bestimmte Metallbearbeitungsanwendungen, insbesondere Drehen und Fräsen, ganz besonders bei Metallbearbeitungsanwendungen mit unterbrochenem Schnitt, die Kombination aus hoher Härte und hohem Elastizitätsmodul besonders vorteilhaft. Die hohe Härte sorgt für hohe Verschleißbeständigkeit. Eine hohe Härte geht jedoch üblicherweise mit einer erhöhten Brüchigkeit einher. Der hohe Elastizitätsmodul sorgt gleichzeitig dafür, dass das Material eine geringere Brüchigkeit aufweist und beispielsweise beim unterbrochenen Schnitt auftretende starke mechanische Wechselbelastungen besser kompensieren kann. Durch die erfindungsgemäße Lagenabfolge erhält die Verschleißschutzbeschichtung des Werkzeugs diese vorteilhaften Eigenschaften.

Die für bevorzugte Ausführungsformen der Erfindung vorgenannten Härte- und Elastizitätsmodulwerte der erfindungsgemäßen Verschleißschutzbeschichtung werden an dem Lagenverbund der Verschleißschutzbeschichtung gemessen und beziehen sich auf diesen, jedoch ohne eine gegebenenfalls als äußerste Lage vorhandene Verschleißindikatorschicht. Eine Verschleißindikatorschicht kann eine andere Funktion erfüllen als die Lagen der Verschleißschutzbeschichtung, wie oben beschrieben, und daher weicher sein und/oder einen abweichenden Elastizitätsmodul aufweisen. Eine Messung von Härte- und Elastizitätsmodulwerten der Verschleißschutzbeschichtung sollte daher ohne eine darüber angeordnete Verschleißindikatorschicht durchgeführt werden, wenn zu erwarten ist, dass die Verschleißindikatorschicht aufgrund ihrer Dicke und/oder Zusammensetzung die Messergebnisse wesentlich beeinflussen wird.

Das erfindungsgemäße Werkzeug kann als Vollhartmetallwerkzeug oder als Wendeschneidplatte ausgebildet sein, wobei das erfindungsgemäße Werkzeug vorzugsweise eine Wendeschneidplatte ist. Ganz besonders überragende Eigenschaften zeigt das erfindungsgemäße Werkzeug bei der Verwendung als Kopierschlichtplatte zum Hartfräsen von Stählen.

In einer weiteren bevorzugten Ausführungsform des erfindungsgemäßen Werkzeugs weist die Verschleißschutzbeschichtung eine mittlere Oberflächenrauheit Ra, gemessen über eine Länge von 10 µm, von ≤ 1,0 µm, vorzugsweise ≤ 0,5 µm auf.

Zur Glättung der Oberfläche des Werkzeugs nach dem Abscheiden der Beschichtung eignen sich bekannte Strahlverfahren, Schleifen oder Bürsten mit entsprechend harten und feinen Materialien. Ein zur Glättung der Oberfläche des Werkzeugs geeignetes Verfahren ist beispielsweise Nassstrahlen mit Glasperlen bei einem Druck von etwa 2,5 bar mit einem Strahlmedium aus 50% Glasperlen mit einem Durchmesser von 70-110 µm und 50% Glasperlen mit einem Durchmesser von 40-70 µm. Die geeignete Strahlbehandlungsdauer ist durch Prüfung der gewünschten Oberflächenglätte zu ermitteln.

Ein weiteres geeignetes Verfahren zur Glättung der Oberfläche des Werkzeugs ist Schleppschleifen. Ein geeignetes Schleifmittel ist beispielsweise ein Kokosnussschalengranulat mit feinem Diamantpulver als Schleifmittel und Haftöl. Auch das Nassstrahlen mit Korund mit beispielsweise der Körnung 280/320 und einer Strahlmittelkonzentration in der Flüssigkeit von etwa 18% ist insbesondere für eine Nachbehandlung geeignet. Hierbei wird zweckmäßigerweise ein Strahldruck von etwa 1,5 bis 2 bar angewendet, wobei Strahlrichtung und Strahlwinkel in Abhängigkeit vom Werkzeugtyp und der Werkzeuggröße einzustellen sind.

Die Oberflächenrauheit wurde zu Zwecken der Erfindung an polierten Test-Wendeschneidplatten mit einem Messgerät Hommel-ETAMIC TURBO WAVE V7.32 der Firma HOMMEL-ETAMIC GmbH, Schwenningen, Deutschland, gemessen (Taster: TKU300 - 96625_TKU300/TS1; Messbereich: 80µm; Teststrecke: 4,8mm; Geschwindigkeit: 0,5mm/s).

### Herstellung der erfindunqemäßen Verschleißschutzbeschichtung

Die Herstellung der erfindungsgemäßen Hartstofflagen erfolgt im PVD-Verfahren, ausgewählt unter Lichtbogenverdampfen, Magnetron-, dualem Magnetron- oder HIPIMS-Verfahren, wobei auch Kombinationen der vorgenannten Verfahren angewendet werden können. Für die Abscheidung der erfindungsgemäßen Hartstofflagen wurde eine Beschichtungsanlage vom Typ Innova der Firma Balzers mit rotierendem Substratträger verwendet. Als Targets wurden schmelzmetallurgisch oder pulvermetallurgisch hergestellte Ti-Al-Targets für die Herstellung der Lagen (A) und Ti-Si-Targets sowie Al-Cr-Targets für die Herstellung der Lagen (B) und Ti-Si-Targets für die Herstellung der Lagen (C) mit den jeweils geeigneten Mengenanteilen der jeweiligen Metalle verwendet.

Die Dicke der einzelnen Lagen lässt sich unter anderem durch die Einstellen der Abscheidungsparameter, wie Temperatur, Biasspannung, Partialdrücke der eingeleiteten Gase, etc. sowie durch die Anordnung der Targets und die Einstellung der jeweiligen Substratbewegung bzw. -drehung in der Beschichtungsanlage beeinflussen. Dem Fachmann ist jedoch bekannt, wie er je nach Anlagentyp die entsprechenden Einstellungen vorzunehmen hat. Vor der Beschichtung wurden die Substrate einer Ätzreinigung durch Ar-Ionen unterzogen, was dem Fachmann ebenfalls geläufig ist.

Härte und E-Modul (genauer der sogenannte reduzierte E-Modul) werden mittels Nanoindentierung gemessen. Hierbei wird ein Diamant-Prüfkörper nach Vickers in die Schicht gedrückt und während der Messung die Kraft-Weg-Kurve aufgezeichnet. Aus dieser Kurve können dann die mechanischen Kennwerte des Prüflings berechnet werden, unter anderem Härte und (reduzierter) E-Modul. Für die Bestimmungen der Härte und des E-Moduls der erfindungsgemäßen Schicht wurde ein Fischerscope® H100 XYp der Firma Helmut Fischer GmbH, Sindelfingen, Deutschland, verwendet. Zu beachten ist, dass die Eindrucktiefe nicht mehr als 10% der Schichtdicke betragen sollte, da ansonsten Eigenschaften des Substrates die Messungen verfälschen können.

Eigenspannungen in der erfindungsgemäßen Schicht lassen sich durch Röntgendiffraktion überprüfen. Dabei lassen sich Eigenspannungen erster, zweiter und dritter Ordnung unterscheiden, die sich in ihrer Reichweite und damit in ihrer Auswirkung auf die Schichthaftung unterscheiden. Für die Haftung der Verschleißschutzbeschichtung auf dem Grundkörper hat es sich als vorteilhaft erwiesen, wenn in der Beschichtung die Eigenspannungen erster und zweiter Ordnung nicht zu hoch werden, zweckmäßigerweise nicht höher als - 5 GPa (Druckspannung).

In einer weiteren bevorzugten Ausführungsform der Erfindung weist das Werkzeug weiterhin eine verrundete Schneidkante mit einem Kantenradius im Bereich von 3 bis 10 µm, vorzugsweise von 5 bis 7 µm auf. Bei zu geringem Schneidkantenradius besteht die Gefahr, dass die Kante schnell abbricht. Ein zu hoher Schneidkantenradius hat sehr hohe Schnittkräfte zur Folge, die sich ungünstig auf die Lebensdauer des Werkzeugs und die Spanformen auswirken.

Weitere Vorteile, Merkmale und Ausführungsformen der vorliegenden Erfindung werden anhand der nachfolgenden Beispiele weiter erläutert.

### Beispiele

### Beispiel 1 - Wendeschneidplatten für Kopierschlichtfräser

Wendeschneidplatten für Kopierschlichtfräser der Plattenformbezeichnung P3204-D16 der Walter AG, Tübingen, Deutschland, aus einer Feinkorn-Hartmetallsorte mit 7 Gew.-% Co und einer WC-Korngröße von etwa 1µm wurden mit erfindungsgemäßen Beschichtungen und einer Vergleichsbeschichtung nach dem Stand der Technik versehen und die beschichteten Werkzeuge in Zerspanversuchen verglichen. Hierin angegebene Zusammensetzungen von Mischtargets bezeichnen Atom-%-Verhältnisse der enthaltenen Metalle.

### Beispiel 1 a (Erfindung)

| | |
|---|---|
| Lagenfolge: | [A-B]₁ |

### Herstellung:

| | |
|---|---|
| Lage (A): | Lichtbogenverdampfen; Ti-Al-Mischtarget (Ti:Al = 50:50); Bias: 120 V DC; 4 Pa N₂; 160 A Verdampferstrom; Abscheidetemperatur: 550 °C; Lagendicke: 150 nm |
| Lage (B): | Lichtbogenverdampfen; Ti-Si-Mischtarget (Ti:Si = 85:15) und Al-Cr-Mischtarget (Al:Cr = 70:30); Bias: 120 V DC; 4 Pa N₂; 160 A Verdampferstrom; Abscheidetemperatur: 550 °C; rotierender Substratträger |
| | Lagendicke: 1,85 µm |
| | Dicken der einzelnen Sub-Lagen TiSiN und AICrN: etwa 7 nm |
| | Anzahl der einzelnen Sub-Lagen TiSiN und AICrN: jeweils etwa 132 |

### Gesamtdicke der Verschleißschutzschicht: 2 µm

| | |
|---|---|
| Härte: | 3700 HV |
| E-Modul: | 420 GPa |

### Beispiel 1 b (Erfindung)

| | |
|---|---|
| Lagenfolge: | [A - B]₂₀ |

### Herstellung:

| | |
|---|---|
| Lage (A): | Lichtbogenverdampfen; Ti-Al-Mischtarget (Ti:Al = 50:50); Bias: 120 V DC; 4 Pa N₂; 160 A Verdampferstrom; Abscheidetemperatur: 550 °C; |
| | Lagendicke: 50 nm |
| Lage (B): | Lichtbogenverdampfen; Ti-Si-Mischtarget (Ti:Si = 85:15) und Al-Cr-Mischtarget (Al:Cr = 70:30); Bias: 120 V DC; 4 Pa N₂; 160 A Verdampferstrom; Abscheidetemperatur: 550 °C; rotierender Substratträger |
| | Lagendicke: 56 nm |
| | Dicken der einzelnen Sub-Lagen TiSiN und AICrN: etwa 7 nm |
| | Anzahl der einzelnen Sub-Lagen TiSiN und AICrN: jeweils etwa 4 |

### Gesamtdicke der Verschleißschutzschicht: 2,2 µm

| | |
|---|---|
| Härte: | 3450 HV |
| E-Modul: | 420 GPa |

### Beispiel 1 c (Erfindung)

| | |
|---|---|
| Lagenfolge: | [A - B]₁₀ - C |

### Herstellung:

| | |
|---|---|
| Lage (A): | Lichtbogenverdampfen; Ti-Al-Mischtarget (Ti:Al = 50:50); Bias: 120 V DC; 4 Pa N₂; 160 A Verdampferstrom; Abscheidetemperatur: 550 °C; Lagendicke: 50 nm |
| Lage (B): | Lichtbogenverdampfen; Ti-Si-Mischtarget (Ti:Si = 85:15) und Al-Cr-Mischtarget (Al:Cr = 70:30); Bias: 120 V DC; 4 Pa N₂; 160 A Verdampferstrom; Abscheidetemperatur: 550 °C; rotierender Substratträger |
| | Lagendicke: 56 nm |
| | Dicken der einzelnen Sub-Lagen TiSiN und AICrN: etwa 7 nm |
| | Anzahl der einzelnen Sub-Lagen TiSiN und AICrN: jeweils etwa 4 |
| Lage (C): | Lichtbogenverdampfen; Ti-Si-Mischtarget (Ti:Si = 85:15) und Al-Cr-Mischtarget (Al:Cr = 70:30); Bias: oszillierend (0,004 Hz) 60 V bzw. 120 V DC; 4 Pa N₂; 160 A Verdampferstrom; Abscheidetemperatur: 550 °C; rotierender Substratträger Lagendicke: 1,0 µm |

### Gesamtdicke der Verschleißschutzschicht: 2,1 µm

| | |
|---|---|
| Härte: | 3900 HV |
| E-Modul: | 430 GPa |

### Beispiel 1 d (Vergleich)

### Herstellung:

| | |
|---|---|
| Lage TiAIN: | Lichtbogenverdampfen; Ti-Al-Mischtarget (Ti:Al = 33:67); Bias: 120 V DC; 4 Pa N₂; 160 A Verdampferstrom; Abscheidetemperatur: 550 °C; |
| | Lagendicke: 2,3 µm |
| Härte: | 3400 HV |
| E-Modul: | 380 GPa |

### Zerspanversuche

Die beschichteten Werkzeuge wurden in Fräsversuchen verglichen und der maximale Freiflächenverschleiß V_{bmax} bei 1 bis 8 Überlaufen über die gekrümmte Werkstückfläche ermittelt. Die in der nachfolgenden Tabelle 1 angegebenen Ergebnisse sind Mittelwerte aus je zwei Versuchen für jedes Werkzeug und für jede Anzahl an Überläufen.

| | |
|---|---|
| Werkstück: | Stahl 60HRC |
| Zerspanbedingungen: | Schnittgeschwindigkeit v_{c} = 250 m/min |
| | Zahnvorschub f_{z} = 0,1 mm |
| | Eingriffstiefe aₚ = 0,5 mm |
| | Eingriffstiefe aₑ = 0,5 mm |
| | Auskragung xₛ = 147,44 mm |
| | Fräsen ohne Kühlung |

**Tabelle 1**

| Anzahl Überläufe | 1 | 2 | 3 | 4 | 5 | 6 | 7 | 8 |
|---|---|---|---|---|---|---|---|---|
| | Verschleiß V_{b}max [mm] | | | | | | | |
| Bsp. 1 a (Erfindung) | 0,03 | 0,04 | 0,08 | 0,09 | 0,11 | 0,12 | 0,15 | 0,18 |
| Bsp. 1 b (Erfindung) | 0,03 | 0,04 | 0,0,7 | 0,08 | 0,10 | 0,11 | 0,13 | 0,15 |
| Bsp. 1 d (Vergleich) | 0,06 | 0,07 | 0,1 | 0,12 | 0,14 | 0,2 | --- | --- |

## Patentansprüche

1. Werkzeug mit einem Grundkörper aus Hartmetall, Cermet, Keramik, Stahl oder Schnellarbeitsstahl und einer auf dem Grundkörper im PVD-Verfahren aufgebrachten mehrlagigen Verschleißschutzbeschichtung, **dadurch gekennzeichnet, dass** die Verschleißschutzbeschichtung
wenigstens eine Lage
(A) TiₐAl₍₁₋ₐ₎ N mit 0,33 ≤ a ≤ 1 und mit einer Lagendicke von 20 nm bis 3 µm und wenigstens eine Lage
(B) aus einer Abfolge von wenigstens 4 abwechselnd übereinander angeordneten Sub-Lagen Ti_{b}Si_{(1-b)}N und Al_{c}Cr_{(1-c)}N mit 0,70 ≤ b ≤ 0,98 und 0,3 ≤ c ≤ 0,75 und mit einer Lagendicke der Sub-Lagen von 0,5 nm bis 15 nm umfasst
und optional weiterhin wenigstens eine Lage
(C) Ti_{d}Si_{(1-d)} N mit 0,70 ≤ d ≤ 0,98 und mit einer Lagendicke von 50 nm bis 1 µm umfasst,
wobei die Verschleißschutzbeschichtung weitere Hartstofflagen aufweisen kann und wobei die Lagen (A), (B) und (C) verfahrensbedingt pro Lage bis zu 10 At.-% weitere Metalle, B, C und/oder O enthalten können.

2. Werkzeug nach Anspruch 1, **dadurch gekennzeichnet, dass** die Lage (B) eine Abfolge von wenigstens 4 Sub-Lagen Ti_{b}Si_{(1-b)} und 4 Sub-Lagen Al_{c}Cr_{(1-c)}N abwechselnd übereinander angeordnet aufweist und/oder dass die Lage (B) eine Abfolge von höchsten 1500 Sub-Lagen Ti_{b}Si_{(1-b)} und 1500 Sub-Lagen Al_{c}Cr_{(1-c)}N abwechselnd übereinander angeordnet aufweist.

3. Werkzeug nach einem der vorausgehenden Ansprüche, **dadurch gekennzeichnet, dass** die Lage (B) eine Gesamtlagendicke von 40 nm bis 3 µm aufweist.

4. Werkzeug nach einem der vorausgehenden Ansprüche, **dadurch gekennzeichnet, dass** die Verschleißschutzbeschichtung eine der folgenden Lagenabfolgen aufweist, wobei m, n, o, p, q und r ganze Zahlen > 0 sind:
| | |
|---|---|
| [A-B]ₙ | mit 1≤n≤100, vorzugsweise 1≤n≤20, |
| ([A-B]ₙ-C)ₘ | mit 1≤n≤100, vorzugsweise 1≤n≤20, und 1≤m≤20, vorzugsweise 1≤m≤5 |
| A-[B-C]ₙ | mit 1≤n≤30 |
| [A-B-C]ₙ | mit 2≤n≤30 |
| {([A-B]ₒ-C)_{q}-(A-[B-C]ₚ)ᵣ}ₘ | mit 1≤o≤30, 1≤p≤30, 1≤q≤30, p+q≥2, (13q+25r)m≤500. |

5. Werkzeug nach einem der vorausgehenden Ansprüche, **dadurch gekennzeichnet, dass** die Sub-Lagen Ti_{b}Si_{(1-b)}N und Al_{c}Cr_{(1-c)}N Lagendicken von 1,0 nm bis 12 nm, vorzugsweise 3,0 nm bis 9,0 nm aufweisen.

6. Werkzeug nach einem der vorausgehenden Ansprüche, **dadurch gekennzeichnet, dass** die Sub-Lagen Ti_{b}Si_{(1-b)}N und Al_{c}Cr_{(1-c)}N kubisch flächenzentrierte Kristallstruktur aufweisen.

7. Werkzeug nach einem der vorausgehenden Ansprüche, **dadurch gekennzeichnet, dass** die Verschleißschutzbeschichtung eine Gesamtdicke von 0,5 µm bis 10 µm, vorzugsweise von 0,7 µm bis 5 µm, besonders bevorzugt 1,0 µm bis 3,0 µm, ganz besonders bevorzugt 1,5 µm bis 2,5 µm aufweist.

8. Werkzeug nach einem der vorausgehenden Ansprüche, **dadurch gekennzeichnet, dass** die Verschleißschutzbeschichtung weitere Hartstofflagen und/oder wenigstens bereichsweise als äußerste Lage angeordnete dünne Verschleißerkennungsschicht, vorzugsweise eine TiN- oder ZrN-Schicht, mit einer Dicke von 0,1 bis 1,5 µm aufweist.

9. Werkzeug nach einem der vorausgehenden Ansprüche, **dadurch gekennzeichnet, dass** die Verschleißschutzbeschichtung eine Vickers-Härte HV von 2500 bis 4000, vorzugsweise 3000 bis 3500 aufweist.

10. Werkzeug nach einem der vorausgehenden Ansprüche, **dadurch gekennzeichnet, dass** die Verschleißschutzbeschichtung einen Elastizitätsmodul (E-Modul) von > 380 GPa, vorzugsweise von > 400 GPa aufweist.

11. Werkzeug nach einem der vorausgehenden Ansprüche, **dadurch gekennzeichnet, dass** es eine Wendeschneidplatte, vorzugsweise eine Kopierschlichtplatte zum Hartfräsen von Stählen ist und/oder dass es ein Vollhartmetallwerkzeug ist.

12. Werkzeug nach einem der vorausgehenden Ansprüche, **dadurch gekennzeichnet, dass** die Verschleißschutzbeschichtung eine mittlere Oberflächenrauheit Ra, gemessen über eine Länge von 10 µm, von ≤ 1,0 µm, vorzugsweise ≤ 0,5 µm aufweist.

## Claims

1. Tool with a main body made of hard metal, cermet, ceramic, steel or high-speed steel, and a multi-layer wear protection coating which is applied on the main body by the PVD process, **characterised in that** the wear protection coating comprises at least one layer
(A) of TiₐAl₍₁₋ₐ₎N with 0.33 ≤ a ≤ 1 and with a layer thickness of from 20 nm to 3 µm
and at least one layer
(B) of a sequence of at least 4 alternating superposed sublayers of Ti_{b}Si_{(1-b)}N and Al_{c}Cr_{(1-c)}N with 0.70 ≤ b ≤ 0.98 and 0.3 ≤ c ≤ 0.75 and with a layer thickness of the sublayers of from 0.5 nm to 15 nm
and optionally in addition at least one layer
(C) of Ti_{d}Si_{(1-d)}N with 0.70 ≤ d ≤ 0.98 and with a layer thickness of from 50 nm to 1 µm,
wherein the wear protection coating can exhibit further layers of hard material and wherein the layers (A), (B) and (C) can contain up to 10 at. % of further metals, B, C and/or O per layer depending on the process.

2. Tool according to claim 1, **characterised in that** the layer (B) exhibits a sequence of at least 4 sublayers of Ti_{b}Si_{(1-b)} and 4 sublayers of Al_{c}Cr_{(1-c)}N arranged superposed in alternation and/or **in that** the layer (B) exhibits a sequence of at most 1500 sublayers of Ti_{b}Si_{(1-b)} and 1500 sublayers of Al_{c}Cr_{(1-c)}N arranged superposed in alternation.

3. Tool according to one of the preceding claims, **characterised in that** the layer (B) exhibits a total layer thickness of from 40 nm to 3 µm.

4. Tool according to one of the preceding claims, **characterised in that** the wear protection coating exhibits one of the following sequences of layers, in which m, n, o, p, q and r are whole numbers > 0:
| | |
|---|---|
| [A-B]ₙ | with 1≤n≤100, preferably 1≤n≤20, |
| ([A-B]ₙ-C)ₘ | with 1≤n≤100, preferably 1≤n≤20, and 1≤m≤20, preferably 1≤m≤5 |
| A-[B-C]ₙ | with 1≤n≤30 |
| [A-B-C]ₙ | with 2≤n≤30 |
| {([A-B]ₒ₋C}_{q}-(A-[B-G]ₚ)ᵣ}ₘ | with 1≤o≤30, 1≤p≤30, 1≤q≤30, p+q≥2, (13q+25r)m≤500. |

5. Tool according to one of the preceding claims, **characterised in that** the sublayers of Ti_{b}Si_{(1-b)}N and Al_{c}Cr_{(1-c)}N exhibit layer thicknesses of from 1.0 nm to 12 nm, preferably of from 3.0 nm to 9.0 nm.

6. Tool according to one of the preceding claims, **characterised in that** the sublayers of Ti_{b}Si_{(1-b)}N and Al_{c}Cr_{(1-c)}N exhibit a cubically face-centered crystal structure.

7. Tool according to one of the preceding claims, **characterised in that** the wear protection coating exhibits a total thickness of from 0.5 µm to 10 µm, preferably of from 0.7 µm to 5 µm, particularly preferably of from 1.0 µm to 3.0 µm, quite particularly preferably of from 1.5 µm to 2.5 µm.

8. Tool according to one of the preceding claims, **characterised in that** the wear protecction coating exhibits further layers of hard material and/or at least in regions arranged as outermost layer a thin wear recognition layer, preferably a TiN or ZrN layer, with a thickness of from 0.1 to 1.5 µm.

9. Tool according to one of the preceding claims, **characterised in that** the wear protection coating exhibits a Vickers hardness HV of from 2500 to 4000, preferably of from 3000 to 3500.

10. Tool according to one of the preceding claims, **characterised in that** the wear protection coating exhibits a modulus of elasticity (E-modulus) of > 380 GPa, preferably of > 400 GPa.

11. Tool according to one of the preceding claims, **characterised in that** it is an indexable cutter insert, preferably a copying smoothing or finishing cutter for hard milling of steels and/or **in that** it is a solid hard metal tool.

12. Tool according to one of the preceding claims, **characterised in that** the wear protection coating exhibits a mean surface roughness Ra, measured over a length of 10 µm, of ≤ 1.0 µm, preferably ≤ 0.5 µm.

## Revendications

1. Outil comprenant un corps de base en métal dur, cermet, céramique, acier ou acier à coupe rapide et un revêtement multicouche de protection contre l'usure déposé sur le corps de base selon le procédé de dépôt physique en phase vapeur, **caractérisé en ce que** le revêtement de protection contre l'usure comprend au moins une couche
(A) de TiₐAl₍₁₋ₐ₎N avec 0,33 ≤ a ≤ 1 et avec une épaisseur de couche de 20 nm à 3 µm
et au moins une couche
(B) d'une suite d'au moins quatre sous-couches, disposées en alternance les unes sur les autres, de Ti_{b}Si_{(1-b)}N et Al_{c}Cr_{(1-c)}N avec 0,70 ≤ b ≤ 0,98 et 0,3 ≤ c ≤ 0,75 et avec une épaisseur des sous-couches de 0,5 nm à 15 nm
et de manière optionnelle en outre au moins une couche
(C) Ti_{d}Si_{(1-d)}N avec 0,70 ≤ d ≤ 0,98 et avec une épaisseur de couche de 50 nm à 1 µm, le revêtement de protection contre l'usure pouvant comprendre en outre d'autres couches de matériau dur et les couches (A, (B) et (C) pouvant comprendre, en raison du procédé, jusqu'à 10 % d'atome de métaux supplémentaires, B, C et/ou O.

2. Outil selon la revendication 1, **caractérisé en ce que** la couche (B) comprend une suite de couches disposées en alternance les unes sur les autres, d'au moins quatre sous-couches, de Ti_{b}Si_{(1-b)} et quatre sous-couches Al_{c}Cr_{(1-c)}N et/ou que la couche (B) comprend une suite de couches disposées en alternance les unes sur les autres, ne dépassant pas 1500 sous-couches de Ti_{b}Si_{(1-b)} et 1500 sous-couches Al_{c}Cr_{(1-c)}N.

3. Outil selon l'une des revendications précédentes, **caractérisé en ce que** la couche (B) présente une épaisseur totale des couches de 40 nm à 3 µm.

4. Outil selon l'une des revendications précédentes, **caractérisé en ce que** le revêtement de protection contre l'usure comprend une des suites suivantes de couches, m, n, o, p, q et r étant des nombres entiers > 0 :
| | |
|---|---|
| [A-B]ₙ | avec 1 ≤ n ≤ 100, de préférence 1 ≤ n ≤ 20, |
| ([A-B]ₙ-C)ₘ | avec 1 ≤ n ≤ 100, de préférence 1 ≤ n ≤ 20, et avec 1 ≤ m ≤ 20, de préférence 1 ≤ m ≤ 5, |
| A-[B-C]ₙ | avec 1 ≤ n ≤ 30, |
| [A-B-C]ₙ | avec 2 ≤ n ≤ 30, |
| {([A-B]ₒ-C)_{q}-(A-[B-C]ₚ)ᵣ}ₘ | avec 1 ≤ o ≤ 30, 1 ≤ p ≤ 30, 1 ≤ q ≤ 30, p+q ≥ 2, (13q+25r)m ≤ 500. |

5. Outil selon l'une des revendications précédentes, **caractérisé en ce que** les sous-couches de Ti_{b}Si_{(1-b)}N et Al_{c}Cr_{(1-c)}N présentent des épaisseurs de couches de 1,0 nm à 12 nm, de préférence de 3,0 à 9,0 nm.

6. Outil selon l'une des revendications précédentes, **caractérisé en ce que** les sous-couches de Ti_{b}Si_{(1-b)}N et Al_{c}Cr_{(1-c)}N présentent une structure cristalline cubique à faces centrées.

7. Outil selon l'une des revendications précédentes, **caractérisé en ce que** le revêtement de protection contre l'usure présente une épaisseur totale de 0,5 µm à 10 µm, de préférence de 0,7 µm à 5 µm, de manière particulièrement préférée de 1,0 µm à 3,0 µm, de manière extraordinairement préférée de 1,5 µm à 2,5 µm.

8. Outil selon l'une des revendications précédentes, **caractérisé en ce que** le revêtement de protection contre l'usure comprend des couches de matériau dur supplémentaires et/ou, au moins par zones, une couche fine de reconnaissance d'usure disposée comme couche extérieure, de préférence une couche de TiN ou ZrN, ayant une épaisseur de 0,1 µm à 1,5 µm.

9. Outil selon l'une des revendications précédentes, **caractérisé en ce que** le revêtement de protection contre l'usure présente une dureté Vickers HV de 2500 à 4000, de préférence de 3000 à 3500.

10. Outil selon l'une des revendications précédentes, **caractérisé en ce que** le revêtement de protection contre l'usure présente un module d'élasticité (module E) de > 380 GPa, de préférence de > 400 GPa.

11. Outil selon l'une des revendications précédentes, **caractérisé en ce qu'**il est une plaquette réversible, de préférence une plaquette de finition de reproduction pour le fraisage à dur d'aciers et/ou **en ce qu'**il est un outil entièrement en métal dur.

12. Outil selon l'une des revendications précédentes, **caractérisé en ce que** le revêtement de protection contre l'usure présente une rugosité moyenne de surface Ra, mesurée sur une longueur de 10 µm, de ≤ 1,0 µm, de préférence de ≤ 0,5 µm.
